(19) Europäisches Patentamt / European Patent Office / Office européen des brevets

(11) **EP 2 564 478 B1**

(12) **EUROPÄISCHE PATENTSCHRIFT**

(45) Veröffentlichungstag und Bekanntmachung des Hinweises auf die Patenterteilung:
**17.06.2020   Patentblatt 2020/25**

(51) Int Cl.:
*H01S 5/028* (2006.01)      *H01S 5/026* (2006.01)
*H01S 5/10* (2006.01)       *H01S 5/024* (2006.01)
*H01S 5/022* (2006.01)      *H01S 5/0683* (2006.01)
*H01S 5/20* (2006.01)       *H01S 5/22* (2006.01)

(21) Anmeldenummer: **11712555.9**

(22) Anmeldetag: **06.04.2011**

(86) Internationale Anmeldenummer:
**PCT/EP2011/055320**

(87) Internationale Veröffentlichungsnummer:
**WO 2011/128233 (20.10.2011 Gazette 2011/42)**

(54) **LASERLICHTQUELLE**

LASER LIGHT SOURCE

SOURCE DE LUMIÈRE  LASER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.04.2010   DE 102010015197**

(43) Veröffentlichungstag der Anmeldung:
**06.03.2013   Patentblatt 2013/10**

(60) Teilanmeldung:
**20174808.4**

(73) Patentinhaber: **OSRAM Opto Semiconductors GmbH**
**93055 Regensburg (DE)**

(72) Erfinder:
• **BREIDENASSEL, Andreas**
  **93077 Bad Abbach (DE)**
• **AVRAMESCU, Adrian Stefan**
  **93051 Regensburg (DE)**
• **LELL, Alfred**
  **93142 Maxhütte-Haidhof (DE)**
• **TAUTZ, Sönke**
  **93105 Tegernheim (DE)**

(74) Vertreter: **Epping - Hermann - Fischer Patentanwaltsgesellschaft mbH Schloßschmidstraße 5 80639 München (DE)**

(56) Entgegenhaltungen:
WO-A1-2009/080012      DE-A1-102008 012 859
JP-A- 1 096 979        JP-A- 11 068 256
JP-A- 11 224 969       JP-A- 2001 148 545
JP-A- 2002 280 663     JP-A- 2005 101 457
US-A- 3 740 661        US-A1- 2005 269 584
US-A1- 2008 101 422    US-A1- 2008 102 546
US-A1- 2009 028 204    US-A1- 2009 219 967
US-A1- 2010 232 466    US-A1- 2010 295 065

• **VALERIO LAINO ET AL: "Substrate Modes of (Al,In)GaN Semiconductor Laser Diodes on SiC and GaN Substrates", IEEE JOURNAL OF QUANTUM ELECTRONICS, IEEE SERVICE CENTER, PISCATAWAY, NJ, USA, Bd. 43, Nr. 1, 1. Januar 2007 (2007-01-01) , Seiten 16-24, XP011152939, ISSN: 0018-9197, DOI: DOI:10.1109/JQE.2006.884769**

**Beschreibung**

Diese Patentanmeldung beansprucht die Priorität der deutschen Patentanmeldung 102010015197.1.

Es wird eine Laserlichtquelle angegeben.

In vielen Anwendungsbereichen werden erhöhte Anforderungen an die Strahlqualität einer Laserdiode gestellt. Ein Beispiel für solche Anwendungsbereiche mit erhöhten Anforderungen sind beispielsweise Projektionsanwendungen. Da bei solchen Anwendungen üblicherweise ein Laserstrahl auf einen mitunter weit entfernten Betrachtungsschirm gestrahlt wird, bestimmt die Qualität des Fernfeldes des Laserstrahls die Qualität der Projektionsanwendung und damit des Bildes, wie es von einem Betrachter wahrgenommen wird. Die Qualität des Fernfeldstrahlprofils bedingt dabei insbesondere die Fokussierbarkeit und Kollimierbarkeit des Laserstrahls, weshalb bevorzugt monomodige Laserdioden mit einem gaußförmigen Strahlprofil eingesetzt werden. Abweichungen des Fernfeldstrahlprofils vom gaußförmigen Strahlprofil führen zu eingeschränkter Fokussierbarkeit und Kollimierbarkeit.

In der üblichen Produktion von Laserdioden findet man typischerweise einen Anteil von Dioden, die zwar alle Leistungskriterien erfüllen, die jedoch Störungen im vertikalen Fernfeld zeigen. Diese können sich beispielsweise im vertikalen Fernfeldstrahlprofil durch Intensitätsmaxima äußern, die neben dem Hauptemissionskegel in einem bestimmten Winkelbereich auftreten. Aufgrund der oben beschriebenen Nachteile solcher nicht-gaußschen Fernfeldstrahlprofile werden derartige Bauteile üblicherweise verworfen.

Weniger stark ausgeprägte Störungen des vertikalen Fernfeldstrahlprofils führen zwar nicht zwangsläufig zum Verwurf der Laserdioden, können aber dennoch zu gewissen Einbußen in den Abbildungseigenschaften führen. Derartige mehr oder weniger stark ausgeprägte Störungen im vertikalen Fernfeldstrahlprofil liegen bei bekannten Laserdioden vor, da das übliche Epitaxie-Design heutzutage das Fast-Axis-Fernfeldstrahlprofil, also bei kantenemittierenden Laserdioden das vertikale Fernfeldstrahlprofil, nicht hinreichend definiert, um bei allen Bauteilen das gewünschte gaußartige Fernfeldstrahlprofil zu erreichen.

Neben der bereits erwähnten Bauteilselektion aus einer 100%-Messung des Fernfeldes, die zwar erfolgreich eingesetzt wird, gleichzeitig aber die Produktionskosten durch die Yield-Senkung bedingt durch den Verwurf erhöht, oder der Inkaufnahme von Störungen im Fernfeld, die zu Einbußen in der Projektionsabbildung führen, sind auch laterale Chipstrukturen für die Fernfeld-Verbesserung bekannt, so etwa aus der US 7, 103, 082 B2, die jedoch nicht auf das vertikale Fernfeld übertragbar sind.

Bei Festkörperlasern beziehungsweise -systemen können auch so genannte Modenblenden zur Fernfeldverbesserung beitragen. Diese sind jedoch in der Justage sehr aufwändig und zur Verbesserung des vertikalen Fernfeldstrahlprofils von Halbleiterlasern wie etwa Nitrid-basierten Diodenlasern nicht verwendbar. Beispiele von Filterstrukturen in Laserlichtquelle mit vertikalem Fernfeldstrahlenprofil sind in den Druckschriften JP2002280663, US 20080102546, DE102008012859 und US20080101422 offenbart. Auf letzterer basiert die Präambel von Anspruch 1.

Eine Aufgabe zumindest einer Ausführungsform ist es, eine Laserlichtquelle mit einer Halbleiterschichtenfolge zur Abstrahlung kohärenter elektromagnetische Strahlung mit einem vertikalen Fernfeldstrahlprofil anzugeben.

Diese Aufgabe wird durch einen Gegenstand mit den Merkmalen des unabhängigen Patentanspruchs gelöst. Vorteilhafte Ausführungsformen und Weiterbildungen des Gegenstands sind in den abhängigen Ansprüchen gekennzeichnet und gehen aus der nachfolgenden Beschreibungen und den Zeichnungen hervor. Gemäß zumindest einer Ausführungsform umfasst eine Laserlichtquelle zur Abstrahlung von kohärenter elektromagnetischer Strahlung mit einem vertikalen Fernfeldstrahlprofil eine Halbleiterschichtenfolge zur Erzeugung der kohärenten elektromagnetischen Strahlung mit einem Substrat und einem aktiven Bereich auf dem Substrat, wobei die kohärente elektromagnetische Strahlung im Betrieb mindestens von einem Hauptemissionsbereich einer Strahlungsauskoppelfläche mit einer Abstrahlrichtung abgestrahlt wird und die Strahlungsauskoppelfläche durch eine Seitenfläche der Halbleiterschichtenfolge gebildet ist. Weiterhin umfasst die Laserlichtquelle mindestens ein Filterelement, das im Betrieb erzeugte kohärente elektromagnetische Strahlung, die von einem zum Hauptemissionsbereich vertikal versetzten und räumlich getrennten Nebenemissionsbereich der Strahlungsauskoppelfläche abgestrahlt wird, im vertikalen Fernfeldstrahlprofil unterdrückt.

Hier und im Folgenden wird die vom Hauptemissionsbereich abgestrahlte kohärente elektromagnetische Strahlung auch als Hauptemission bezeichnet, während die vom

Nebenemissionsbereich emittierte kohärente elektromagnetische Strahlung auch als Nebenemission bezeichnet wird.

Eine Unterdrückung der kohärenten elektromagnetischen Strahlung, die vom Nebenemissionsbereich der Strahlungsauskoppelfläche ausgestrahlt wird, kann insbesondere bedeuten, dass die durch die Nebenemission hervorgerufenen Störungen im vertikalen Fernfeldstrahlprofil, beispielsweise in Form von einem oder mehreren Nebenpeaks zum Hauptpeak der Hauptemission, vermieden oder beseitigt werden. Somit können mit Vorteil Laserlichtquellen mit einer Halbleiterschichtenfolge genutzt werden, die zwar möglicherweise zusätzlich zur Hauptemission eine Nebenemission aufweisen, bei denen die Nebenemission jedoch vom mindestens einen Filterelement derart unterdrückt wird, dass beispielsweise für Projektionsabbildungen die gewünschten Strahleigenschaften, insbesondere das gewünschte vertikale Fernfeldstrahlprofil, erreicht wird.

Wie weiter unten beschrieben ist, kann die Halbleiterschichtenfolge als epitaktisch aufgewachsene Schichtenfolge ausgeführt sein. Die durch die Epitaxie bestimmte Aufwachsrichtung der Schichten der Halbleiterschichtenfolge wird hier und im Folgen auch als vertikale Richtung bzw. als vertikal bezeichnet. Insbesondere kann die vertikale Richtung der dem Fachmann bekannten "fast axis" der abgestrahlten kohärenten elektromagnetischen Strahlung entsprechen. Das vertikale Fernfeldstrahlprofil bezeichnet dabei das Fernfeldstrahlprofil, das die kohärente elektromagnetische Strahlung in vertikaler Richtung aufweist.

Die kohärente elektromagnetische Strahlung, die im Betrieb vom Hauptemissionsbereich der Strahlungsauskoppelfläche abgestrahlt wird, weist einen Abstrahlkegel auf, dessen Achse der Abstrahlrichtung entspricht.

Bei der hier beschriebenen Laserlichtquelle kann ungeachtet einer möglichen Nebenemission ein höherer Anteil von hergestellten Bauteilen verwendbar sein, wobei das Fernfeld der hier beschriebenen Laserlichtquelle im Vergleich zu bekannten Laserdioden signifikant verbessert werden kann und beispielsweise insbesondere in vertikaler Richtung gaußartig ist. Hierdurch kann eine verbesserte Abbildungsqualität beispielsweise in Projektionsanwendungen erreicht werden. Weiterhin fallen bei der hier beschriebenen Laserlichtquelle nur geringe Zusatzkosten durch das Filterelement an, und die aufwändige Justage zusätzlicher optischer Komponenten kann ganz entfallen.

Die Halbleiterschichtenfolge kann als Epitaxieschichtenfolge oder als strahlungsemittierender Halbleiterchip mit einer Epitaxieschichtenfolge, also als epitaktisch gewachsene Halbleiterschichtenfolge, ausgeführt sein. Durch das epitaktische Wachstum der Halbleiterschichtenfolge ergibt sich eine Aufwachsrichtung, sodass die Halbleiterschichtenfolge eine Unter- und eine Oberseite aufweist, die senkrecht zur Aufwachsrichtung orientiert sind und die durch Seitenflächen der Halbleiterschichtenfolge miteinander verbunden sind, die jeweils parallel zur Aufwachsrichtung stehen können. Die hier beschriebene Laserlichtquelle kann also insbesondere eine Halbleiterschichtenfolge umfassen, deren Strahlungsauskoppelfläche durch eine Seitenfläche gebildet ist und die somit als so genannter kantenemittierender Halbleiterlaser ausgeführt sein kann.

Dabei kann die Halbleiterschichtenfolge beispielsweise auf der Basis eines III-V-Verbindungshalbleitermaterialsystems basieren, insbesondere auf einem oder mehreren der Materialien InGaAlN, InGaAlP oder AlGaAs, wobei die Halbleiterschichtenfolge eine Schichtenfolge aus unterschiedlichen Einzelschichten aufweist, die jeweils eines oder mehrere der vorgenannten Materialsysteme aufweisen kann. Alternativ oder zusätzlich kann die Halbleiterschichtenfolge auch ein II-VI-Verbindungshalbleitermaterialsystem aufweisen. Mit derartigen Materialsystemen sind Halbleiterschichtenfolgen herstellbar, die elektromagnetische Strahlung in einem ultravioletten bis infraroten Wellenlängenbereich und beispielsweise für Projektionsanwendungen bevorzugt in einem sichtbaren Wellenlängenbereich emittieren.

Das Substrat der Halbleiterschichtenfolge, auf dem die Epitaxieschichten aufgebracht sind, kann ein Halbleitermaterial, beispielsweise eines der vorab genannten Verbindungshalbleitermaterialsysteme, umfassen. Insbesondere kann das Substrat Saphir, GaAs, GaP, GaN, InP, SiC, Si und/oder Ge umfassen oder kann aus einem solchen Material sein.

Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur) aufweisen. Die Halbleiterschichtenfolge kann im aktiven Bereich weitere funktionelle Schichten und funktionelle Bereiche umfassen, etwa undotierte oder p- oder n-dotierte Confinement-, Mantel- oder Wellenleiterschichten, Barriereschichten, Planarisierungsschichten, Pufferschichten, Schutzschichten, Passivierungsschichten und/oder Elektrodenschichten sowie Kombinationen daraus. Solche Strukturen den aktiven Bereich betreffend sind dem Fachmann hinsichtlich Aufbau, Funktion und Struktur bekannt und werden daher an dieser Stelle nicht näher erläutert. Darüber hinaus können zusätzliche Schichten, etwa Pufferschichten, Barriereschichten und/oder Schutz- oder Passivierungsschichten auch senkrecht zur Aufwachsrichtung der Halbleiterschichtenfolge beispielsweise auf den Seitenflächen der Halbleiterschichtenfolge aufgebracht sein. Insbesondere können beispielsweise auf der Strahlungsauskoppelfläche eine oder mehrere Passivierungsschichten aufgebracht sein.

Um einen Betrieb der als kantenemittierende Halbleiterlaserdiode ausgeführten Halbleiterschichtenfolge in einer transversalen Grundmode zu ermöglichen, können Schichten der Halbleiterschichtenfolge, die auf zumindest einer Seite des aktiven Bereichs angeordnet sind, beispielsweise steg- und/oder trapezförmig strukturiert sein. Derartige als Stegwellenleiter, Rippenwellenleiter, "Ridge-Struktur", "Trapezstruktur" oder "tapered structure" bekannte Ausgestaltungen der Halbleiterschichtenfolge sind dem Fachmann bekannt und werden hier nicht weiter ausgeführt. Die Strahlungsauskoppelfläche kann insbesondere eine komplette Seitenfläche der Halbleiterschichtenfolge umfassen und somit durch eine Seitenfläche des Substrats sowie den darüber angeordneten Seitenflächen der epitaktisch abgeschiedenen Schichten gebildet sein.

Weiterhin kann die Halbleiterschichtenfolge einen optischen Resonator für die kohärente elektromagnetische Strahlung aufweisen. Der Resonator kann insbesondere einen ersten Spiegel auf der Strahlungsauskoppelfläche und einen zweiten Spiegel auf einer der Strahlungsauskoppelfläche gegenüberliegenden Rückseitenfläche der Halbleiterschichtenfolge umfassen, zwischen denen der aktive Bereich angeordnet ist. Weiterhin kann die Halbleiterschichtenfolge als so genannter "distributed feedback laser", kurz DFB-Laser, ausgeführt sein. Die hier erwähnten Resonatorstrukturen sind dem Fachmann bekannt und werden daher nicht weiter ausgeführt.

Durch die Resonatoreigenschaften sowie die Wellenleitereigenschaften der Halbleiterschichtenfolge kann es zu einer Ausbildung des Nebenemissionsbereichs kommen, der vertikal zum Hauptemissionsbereich versetzt und räumlich von diesem getrennt ist. Die Nebenemission, also die kohärente elektromagnetische Strahlung, die vom Nebenemissionsbereich der Strahlungsauskoppelfläche abgestrahlt wird, kann insbesondere einen Winkel von größer als 0° zur Abstrahlrichtung der Hauptemission aufweisen, wodurch sich im Fernfeldstrahlprofil neben dem Haupt-Peak der Hauptemission ein oder mehrere Seiten-Peaks ausbilden können.

Gemäß einer weiteren Ausführungsform ist das mindestens eine Filterelement geeignet, die vom Hauptemissionsbereich emittierte kohärente elektromagnetische Strahlung nahe der Halbleiterschichtenfolge oder direkt an der Halbleiterschichtenfolge abzuschatten bzw. zu absorbieren. Dazu kann das mindestens eine Filterelement als Raumwinkelabdeckung, beispielsweise als Halbraumabdeckung, ausgeführt sein und dazu eine geeignete Form aufweisen oder auch direkt an der Halbleiterschichtenfolge oder in deren Nähe angeordnet sein. Dadurch kann das mindestens eine Filterelement geeignet sein, die Nebenemission direkt am Emissionspunkt, also direkt am Nebenemissionsbereich oder nahe am Nebenemissionsbereich abzuschatten, wobei mit Vorteil die Hauptemission, also die kohärente elektromagnetische Strahlung, die vom Hauptemissionsbereich der Strahlungsauskoppelfläche emittiert wird, gänzlich oder zumindest nahezu unbeeinflusst und unbeschränkt bleibt. Nachteilige Änderungen des Fernfeldstrahlprofils, wie sie die Verwendung einer Blende im größeren Abstand zur Strahlungsauskoppelfläche zur Folge haben würde, können so mit Vorteil vermieden werden.

Die Laserlichtquelle umfasst weiterhin eine Wärmesenke, auf der die Halbleiterschichtenfolge und das mindestens eine Filterelement angeordnet sind. Insbesondere kann die Halbleiterschichtenfolge mit dem Substrat auf der Wärmesenke angeordnet und montiert, beispielsweise gelötet oder geklebt, sein. Alternativ zur Anordnung der Halbleiterschichtenfolge mit dem Substrat auf der Wärmesenke kann die Halbleiterschichtenfolge auch mit der dem Substrat abgewandten Oberseite der Halbleiterschichtenfolge auf der Wärmesenke aufgebracht werden. Im Hinblick auf die übliche Aufwachsreihenfolge, bei der auf das Substrat zuerst die n-leitenden Schichten und dann darüber abschließend und die Oberseite bildend die p-leitenden Schichten abgeschieden werden, kann eine solche Anordnung auch als p-side-down bezeichnet werden.

Die Wärmesenke kann ein Metall und/oder ein Keramikmaterial mit hoher Wärmeleitfähigkeit aufweisen. Beispielsweise kann die Wärmesenke aus Aluminium oder Kupfer sein, wodurch die Halbleiterschichtenfolge vom Substrat her über die Wärmesenke auch elektrisch kontaktierbar sein kann. Ein Filterelement auf der Wärmesenke ist der Halbleiterschichtenfolge in Abstrahlrichtung der vom Hauptemissionsbereich emittierten elektromagnetischen Strahlung nachgeordnet. Insbesondere kann das Filterelement auf der Wärmesenke einen Raumwinkelbereich überdecken, in den die Nebenemission vom Nebenemissionsbereich der Strahlungsauskoppelfläche emittiert wird. Das Filterelement kann dabei direkt an die Halbleiterschichtenfolge angrenzen oder auch räumlich getrennt, also beabstandet, von der Halbleiterschichtenfolge auf der Wärmesenke angeordnet sein.

Weiterhin weist das Filterelement eine Hauptstreckungsebene auf, die parallel zur Abstrahlrichtung ist. Das bedeutet, dass das Filterelement flächig ausgeführt ist und sich, vertikal zum Hauptemissionsbereich und zum Nebenemissionsbereich versetzt, entlang der Abstrahlrichtung erstreckt. Das Filterelement ist als Teil der Oberfläche der Wärmesenke, auf der die Halbleiterschichtenfolge angeordnet ist, ausgeführt. Dazu erstreckt sich die Wärmesenke von der Strahlungsauskoppelfläche der Halbleiterschichtenfolge aus gesehen in Abstrahlrichtung von der Halbleiterschichtenfolge weg und weist somit einen Teil auf, der vor die Halbleiterschichtenfolge gezogen ist, das heißt, der vor der Halbleiterschichtenfolge angeordnet ist. Die Wärmesenke kann dabei eine Fläche mit einer Vorderkante aufweisen, die einen Abstand zur Strahlungsauskoppelfläche der Halbleiterschichtenfolge aufweist, sodass sich ein Oberflächenbereich der Wärmesenke ergibt, auf den die vom Nebenemissionsbereich abgestrahlte kohärente elektromagnetische Strahlung eingestrahlt wird. Das Filterelement wird dabei durch diesen Oberflächenbereich gebildet.

Das mindestens eine Filterelement kann eine Kombination von Filterelementen aufweisen. Weiterhin kann die Wärmesenke eine der Halbleiterschichtenfolge in Abstrahlrichtung nachgeordnete Stufe aufweisen. Ein Filterelement kann dabei auf einer der Halbleiterschichtenfolge und der Strahlungsauskoppelfläche zugewandten Seitenfläche der Stufe angeordnet sein. Die Höhe der Stufe kann derart ausgeführt sein, dass die Hauptemission von der Strahlungsauskoppelfläche ungestört oder zumindest im Wesentlichen unbeeinflusst emittiert wird, während die Nebenemission abgeschattet wird. Dabei kann das Filterelement durch die der Halbleiterschichtenfolge zugewandten Seitenfläche der Stufe gebildet sein.

Weiterhin kann ein Filterelement einen Absorber, eine Diode und/oder eine Fotodiode umfassen. Der Absorber, die Diode und/oder die Fotodiode können dabei auf der Oberfläche bzw. dem Oberflächenbereich der Wärmesenke angeordnet sein, auf die bzw. den die Nebenemission eingestrahlt wird.

Umfasst das Filterelement eine Diode oder eine Fotodiode, so kann diese gleichzeitig auch als ESD-Schutzdiode ausgeführt sein und entsprechend mit der Halbleiterschichtenfolge verschaltet sein. Dadurch kann es möglich sein, dass die Laserlichtquelle keine weitere ESD-Schutzdiode benötigt, wodurch sich mit Vorteil ein kompakter Aufbau ergeben kann. Umfasst das Filterelement eine Fotodiode, so kann die kohärente elektromagnetische Strahlung, die vom Nebenemissionsbereich der Strahlungsauskoppelfläche abgestrahlt wird, genutzt werden, um die Ausgangsleistung der Laserlichtquelle zu messen und zu monitoren. Die Nutzung einer Fotodiode als Filterelement ermöglicht mit Vorteil einen Synergieeffekt durch den Hinzugewinn der Möglichkeit eines Leistungsmonitoring bei gleichzeitiger Verbesserung des vertikalen Fernfeldstrahlprofils.

Die Laserlichtquelle kann weiterhin auf einem Träger angeordnet sein. Der Träger kann beispielsweise als bekanntes Gehäuse für Halbleiterlaserdioden oder als Teil davon ausgeführt sein. Beispielsweise kann der Träger ein so genanntes TO38-, TO56- oder TO90-Gehäuse oder ein Teil davon sein. Umfasst die Laserlichtquelle eine Wärmesenke, kann die Wärmesenke auf dem Träger derart angeordnet sein, dass Wärme, die im Betrieb in der Halbleiterschichtenfolge entsteht, über die Wärmesenke an den Träger abgeleitet werden kann.

Weiterhin kann das Filterelement zusätzlich oder alternativ einen ersten Absorber für die von der Halbleiterschichtenfolge erzeugte kohärente elektromagnetische Strahlung unmittelbar auf der Strahlungsauskoppelfläche und/oder einen zweiten Absorber unmittelbar auf einer der Strahlungsauskoppelfläche gegenüberliegenden Rückseitenfläche der Halbleiterschichtenfolge aufweisen. Der erste Absorber und/oder der zweite Absorber können dabei auf Beschichtungen, beispielsweise Facetten- und/oder Spiegelbeschichtungen, angeordnet sein. Der erste Absorber kann insbesondere zumindest auf dem Nebenemissionsbereich angeordnet sein. Der zweite Absorber kann mindestens auf dem dem Nebenemissionsbereich gegenüberliegenden Bereich der Rückseitenfläche angeordnet sein. Durch den ersten und/oder zweiten Absorber kann die Nebenemission direkt an der Strahlungsauskoppelfläche und/oder der Rückseitenfläche absorbiert werden.

Als Materialien für einen Absorber für die hier beschriebenen Filterelemente eignen sich insbesondere dielektrische, halbleitende oder metallische Materialien, beispielsweise eines oder mehrere Materialien ausgewählt aus der Gruppe Siliziumoxinitrid, Zirkoniumoxid, Titanoxid, Tantalpentoxid, Tantaldioxid, Aluminiumoxid, Yttriumoxid, Hafniumoxid, Alumimiumoxinitrid, Silizium, Germanium, Zinktellurid, Gold, Titan, Tantal, Niob, Kupfer, Chrom, Palladium, Platin, Nickel und Aluminium. Bei der Verwendung eines dielektrischen Materials, beispielsweise eines der genannten Oxide oder Oxinitride, kann zur Steigerung bzw. Steuerung der absorbierenden Wirkung der Absorber partiell unter Sauerstoffmangel abgeschieden werden. Ein anschließendes Tempern in einer Sauerstoffatmosphäre kann dazu genutzt werden, die Absorption wieder zu verringern bzw. anzupassen.

Diese Anpassung ist möglich über eine Steuerung des Sauerstoffgehalts und der Temperbedingungen. Umfasst der Absorber ein Metall, das direkt auf der Strahlungsauskoppelfläche oder der Rückseitenfläche aufgebracht ist, so kann die Halbleiterschichtenfolge mit Vorteil eine dielektrische Beschichtung, beispielsweise eine Facetten- oder Spiegelbeschichtung auf der entsprechenden Seitenfläche als Strahlungsauskoppelfläche bzw. als Rückseitenfläche zwischen der Halbleiterschichtenfolge und dem Absorber aufweisen. Besonders bevorzugt weist der Absorber ein nicht-sättigbares Material auf.

Weiterhin kann der erste und/oder der zweite Absorber auf der Strahlungsauskoppelfläche bzw. der Rückseitenfläche mittels eines so genannten selbstjustierenden Verfahrens aufgebracht werden. Das kann insbesondere bedeuten, dass die vom Hauptemissionsbereich abgestrahlte elektromagnetische Strahlung zu einer selbstjustierenden Verringerung der Absorptionswirkung des ersten Absorbers im Hauptemissionsbereich und/oder des zweiten Absorbers in einem dem Hauptemissionsbereich gegenüberliegenden Bereich führen kann. Dazu kann auf die gesamte Strahlungsauskoppelfläche und/oder Rückseitenfläche ein geeignetes Material, beispielsweise eine Polymerschicht, eine kohlenstoffhaltige Schicht, eine absorbierende Oxidschicht und/oder eine dünne Metallschicht aufgebracht werden, die bei Inbetriebnahme der Halbleiterschichtenfolge im Bereich des Hauptemissionsbereichs bzw. des dem Hauptemissionsbereich gegenüberliegenden Bereichs der Rückseitenfläche durch die kohärente elektromagnetische Strahlung gänzlich oder teilweise weggebrannt oder in der Absorptivität verändert wird. Dies kann in einer kontrollierten Atmosphäre, beispielsweise einer Sauerstoff- oder Ozonatmosphäre, geschehen. Dabei ist das Material des Absorbers und dessen Dicke derart gewählt, dass die Intensität der Nebenemission nicht ausreicht, die Absorberschicht wegzubrennen oder in ihrer Absorptivität zu verändern, sodass der erste bzw. zweite Absorber eine Art selbstjustierende Blende bilden.

Die vorgenannten Filterelemente haben den Vorteil, dass in den Herstellungsprozess der Halbleiterschichtenfolge selbst nicht eingegriffen werden muss, wodurch sich eine Risikominimierung durch eine hohe Prozesssicherheit ergibt.

Gemäß einer weiteren Ausführungsform kann ein Filterelement zumindest eine Absorberschicht zwischen dem Hauptemissionsbereich und dem Substrat umfassen, die ein die kohärente elektromagnetische Strahlung absorbierendes, halbleitendes Material aufweist. Die Absorberschicht kann dabei während des epitaktischen Wachstums der Halbleiterschichtenfolge vor dem aktiven Bereich auf dem Substrat aufgebracht werden. Dadurch kann die Wellenführung und die Ausbreitung der kohärenten elektromagnetischen Strahlung innerhalb der Halbleiterschichtenfolge außerhalb des aktiven Bereichs und insbesondere im Bereich des Nebenemissionsbereichs derart unterdrückt werden, dass vom Nebenemissionsbereich keine oder im Wesentlichen keine elektromagnetische Strahlung mehr emittiert wird. Weiterhin kann das Filterelement eine Mehrzahl von Absorberschichten aufweisen, die weiterhin besonders bevorzugt in einem Abstand von λ/4 zueinander angeordnet sein können, wobei λ einer mittleren Wellenlänge der von der Laserlichtquelle abgestrahlten elektromagnetischen Strahlung bezeichnet.

Die Absorberschicht kann im Falle einer Nitrid-basierten Halbleiterschichtenfolge beispielsweise eine dünne InGaN-Schicht aufweisen, die eine hohe Defektdichte aufweist, wodurch eine Unterdrückung der Nebenemission durch Ausnutzung der Defekt-Absorption in der Absorberschicht erreicht werden kann. Die defektreichen Gebiete innerhalb der Absorberschicht bzw. die hohe Defektdichte kann beispielsweise durch Tempern erzeugt werden. Weiterhin kann die absorbierende Schicht auch InGaN-Inhomogenitäten aufweisen, sodass eine Bandkantenabsorption in In-reichen Bereichen stattfinden kann.

Weiterhin kann zwischen der zumindest einen Absorberschicht und dem Substrat eine reflektierende Schicht angeordnet sein. Die reflektierende Schicht, die beispielsweise ein halbleitendes oder ein metallisches Material umfassen kann und auch als Schichtenfolge ausgebildet sein kann, kann mit Vorteil die im ersten Durchgang durch die Absorberschicht durchtretende kohärente elektromagnetische Strahlung reflektieren, sodass diese ein zweites Mal die Absorberschicht durchlaufen muss, wodurch mit Vorteil eine stärkere Unterdrückung und Absorption möglich sein kann.

Gemäß einer weiteren Ausführungsform umfasst ein Filterelement zumindest eine Ausnehmung in einer dem aktiven Bereich gegenüberliegenden Unterseite des Substrats. Die Ausnehmung kann sich dabei von der Unterseite des Substrats in Richtung des aktiven Bereichs in das Substrat hinein erstrecken. Insbesondere kann sich die zumindest eine Ausnehmung derart weit in das Substrat hinein erstrecken, dass sie sich in vertikaler Richtung mit dem Nebenemissionsbereich überdeckt, sodass die zumindest eine Ausnehmung in den Bereich im Substrat hineinragen kann, in dem die Wellenführung für die vom Nebenemissionsbereich abgestrahlte kohärente elektromagnetische Strahlung innerhalb des Substrats erfolgt. Durch eine derartige Strukturierung der Substratunterseite kann die Nebenemission reduziert oder gar unterbunden werden.

Die zumindest eine Ausnehmung kann eine Vertiefung, eine Bohrung, einen Graben, eine Öffnung und/oder ein Sackloch umfassen. Die zumindest eine Ausnehmung kann dabei beispielsweise durch Ansägen, Bohren, Fotostrukturieren, Trockenätzen, Nassätzen oder eine Kombination daraus erzeugt werden. Die zumindest eine Ausnehmung kann von der Strahlungsauskoppelfläche und/oder von der der Strahlungsauskoppelfläche gegenüberliegenden Rückseitenfläche des Substrats jeweils beabstandet sein. Dies kann insbesondere bedeuten, dass sich die zumindest eine Ausnehmung entlang der Abstrahlrichtung nicht durch das ganze Substrat hindurch erstreckt.

Weiterhin kann die zumindest eine Ausnehmung auch eine Mehrzahl von Ausnehmungen umfassen. Diese können beispielsweise in Abstrahlrichtung und/oder in lateraler Richtung, also senkrecht zur Abstrahlrichtung, nebeneinander angeordnet sein. Die zumindest eine Ausnehmung kann dabei eine oder mehrere Sacklöcher und/oder gerade oder geknickte Kanäle entlang und/oder quer zur Abstrahlrichtung aufweisen. Die Mehrzahl von Ausnehmungen können entlang der Abstrahlrichtung und/oder quer zur Abstrahlrichtung periodisch oder auch nicht periodisch, also unregelmäßig, angeordnet sein.

Weiterhin kann die zumindest eine Ausnehmung auch Teil einer Aufrauung der Substratunterseite sein. Die Rauhigkeit der Aufrauung kann dabei derart ausgebildet sein, dass sich die zumindest eine Ausnehmung und damit die Aufrauung in den Teil des Substrats hineinerstreckt, in dem sich die vom Nebenemissionsbereich abgestrahlten elektromagnetische Strahlung ausbreiten kann. Die Aufrauung kann beispielsweise mittels Sägen und/oder Ätzen hergestellt werden oder zusätzlich oder alternativ mit einem Laser eingraviert werden.

Weiterhin kann sich die zumindest eine Ausnehmung auch von der Strahlungsauskoppelfläche zu der Strahlungsauskoppelfläche gegenüberliegenden Rückseitenfläche des Substrats erstrecken. Dies kann insbesondere bedeuten, dass die zumindest eine Ausnehmung als Längskanal ausgebildet ist, der sich in Abstrahlrichtung ganz durch das Substrat hindurch erstreckt. Weiterhin kann sich eine solche, in Abstrahlrichtung gänzlich durch das Substrat erstreckende Vertiefung auch in lateraler Richtung, also quer zur Abstrahlrichtung, ganz durch das Substrat hindurch erstrecken. Das kann auch bedeuten, dass das Filterelement dadurch hergestellt wird, dass es vollständig oder zumindest teilweise von der Unterseite her entfernt wird. Dadurch kann auch der Teil des Substrats, in dem die vom Nebenemissionsbereich der Strahlungsauskoppelfläche abgestrahlte kohärente elektromagnetische Strahlung innerhalb des Substrats geführt wird, entfernt werden, sodass kein Nebenemissionsbereich im obigen Sinne mehr vorhanden ist.

Weiterhin kann die zumindest eine Ausnehmung zumindest teilweise mit einem die kohärente elektromagnetische Strahlung absorbierenden Material und/oder einem Wärme leitenden Material gefüllt sein. Dadurch kann eine bessere Unterdrückung der vom Nebenemissionsbereich abgestrahlten kohärenten elektromagnetischen Strahlung und/oder eine verbesserte Wärmeanbindung beispielsweise an eine Wärmesenke erzielt werden. Als geeignete Materialien für das absorbierende Material und/oder das Wärme leitende Material eignen sich die oben im Zusammenhang mit dem ersten und zweiten Absorber genannten Materialien.

Gemäß einer weiteren Ausführungsform umfasst die Ausnehmung eine Anschrägung des Substrats an der Strahlungsauskoppelfläche. Zumindest ein Teil der Anschrägung umfasst dabei den Nebenemissionsbereich, wohingegen sich die Anschrägung nicht bis zum Hauptemissionsbereich erstreckt. Dadurch kann mit Vorteil erreicht werden, dass die Nebenemission aus der Abstrahlrichtung der Hauptemission herausgelenkt wird und somit im wahrgenommenen Fernfeld nicht mehr vorhanden ist.

Weitere Vorteile und vorteilhafte Ausführungsformen und Weiterbildungen der Erfindung ergeben sich aus den im Folgenden in Verbindung mit den Figuren 1A bis 12B beschriebenen Ausführungsformen.

Es zeigen:

> Figuren 1A und 1B eine schematische Darstellung einer Halbleiterschichtenfolge zur Abstrahlung von kohärenter elektromagnetischer Strahlung sowie ein Fernfeldstrahlprofil,
> Figuren 2A bis 2C schematische Darstellungen von Laserlichtquellen gemäß einiger Ausführungsbeispiele,
> Figuren 3 bis 11C schematische Darstellungen von Laserlichtquellen, die in Verbindung mit dem Filterelement aus der Figur 2A weitere Ausführungsbeispiele darstellen, und
> Figuren 12A und 12B Fernfeldstrahlprofile von Laserlichtquellen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, z. B. Schichten, Bauteile, Bauelemente und Bereiche, zur besseren Darstellbarkeit und/oder zum besseren Verständnis übertrieben dick oder groß dimensioniert dargestellt sein.

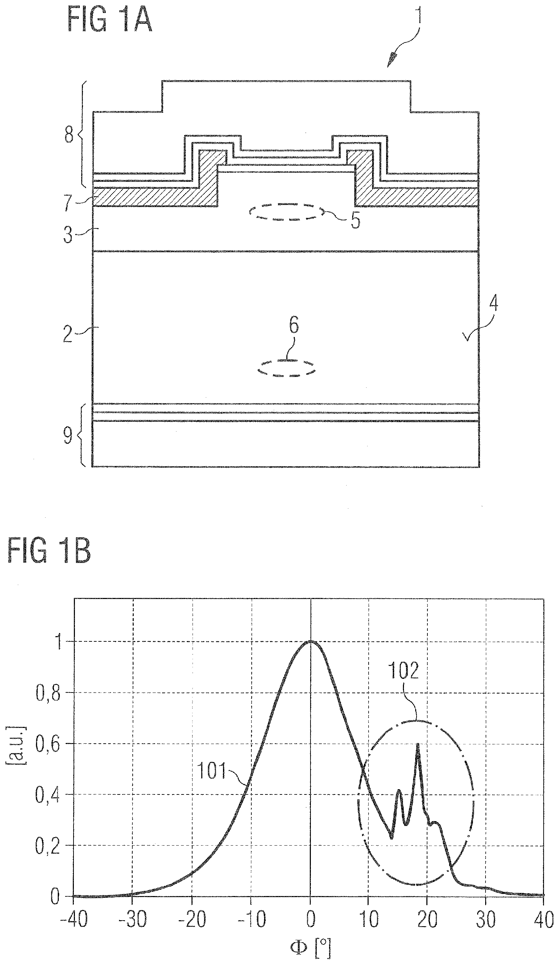

In Figur 1 ist eine Halbleiterschichtenfolge 1 zur Erzeugung von kohärenter elektromagnetischer Strahlung gezeigt. Rein beispielhaft ist dabei eine Halbleiterschichtenfolge 1 gezeigt, die auf einem Nitrid-Halbleiterverbundsystem basiert. Alternativ dazu kann die Halbleiterschichtenfolge auch andere, im allgemeinen Teil beschriebene Materialsysteme aufweisen oder aus solchen bestehen.

Die Halbleiterschichtenfolge 1 weist ein etwa 110 $\mu$m dickes n-dotiertes GaN-Substrat 2 auf, auf dem ein aktiver Bereich 3 epitaktisch abgeschieden ist. Der aktive Bereich 3 umfasst mehrere Einzelschichten, die der Übersichtlichkeit halber nicht gezeigt sind. Der aktive Bereich 3 weist insbesondere eine aktive Schicht zwischen n- und p-Mantel- und Wellenleiterschichten auf, die im gezeigten Ausführungsbeispiel auf einem GaN-Verbindungshalbleitermaterialsystem basieren und Eigenschaften und Zusammensetzungen aufweisen, wie im allgemeinen Teil beschrieben ist. Der aktive Bereich 3 ist als Stegwellenleiter strukturiert, über dessen Seitenflanken eine Passivierungsschicht 7, beispielsweise mit SiOx, AlOx und/oder SiNi abgeschieden ist.

Zur elektrischen Kontaktierung weist die Halbleiterschichtenfolge 1 auf der Passivierungsschicht 7 und dem aktiven Bereich 3 einen Kontaktschichtenstapel 8 mit einer Mehrzahl von Schichten auf, die beispielsweise Nickel, Platin, Palladium, Titan und/oder Gold aufweisen können, während auf der dem aktiven Bereich 3 abgewandten Substratunterseite eine weitere elektrische Kontaktschichtenfolge 9 mit einer Mehrzahl von metallischen Schichten aufgebracht ist. Der Aufbau der in Figur 1A gezeigten, als kantenemittierender Halbleiterlaser mit einer Stegwellenleiterstruktur ausgeführten Halbleiterschichtenfolge sowie Modifikationen dieser sind dem Fachmann bekannt und werden daher hier nicht weiter ausgeführt. Insbesondere sind die folgenden Ausführungsbeispiele nicht auf die in Figur 1A gezeigte Halbleiterschichtenfolge 1 festgelegt.

Die Halbleiterschichtenfolge in Figur 1A ist in einer Frontdarstellung mit Sicht auf die Strahlungsauskoppelfläche 4 dargestellt. Diese kann, wie beispielsweise auch eine der Strahlungsauskoppelfläche 4 gegenüberliegende Rückseitenfläche der Halbleiterschichtenfolge 1 eine oder mehrere Spiegel- und/oder Passivierungsschichten aufweisen (nicht gezeigt). Im aktiven Bereich 3 ist ein Hauptemissionsbereich 5 mittels einer gestrichelten Linie angedeutet, in dem kohärente elektromagnetische Strahlung im Betrieb mit einer Abstrahlrichtung abgestrahlt wird, die in der gezeigten Darstellung senkrecht zur Papierebene aus dieser heraus ragt. Die Strahlungsauskoppelfläche 4 ist somit durch eine Seitenfläche der Halbleiterschichtenfolge 1 gebildet, die eine Seitenfläche des aktiven Bereichs 3 sowie eine Seitenfläche des Substrats 2 umfasst. Auf der Seitenfläche des Substrats 2 ist ein Nebenemissionsbereich 6 mittels einer gestrichelten Linie angedeutet, der vertikal zum Hauptemissionsbereich 5 versetzt ist und räumlich von diesem getrennt ist. Im gezeigten Ausführungsbeispiel weist der Nebenemissionsbereich 6 einen Abstand von etwa 80 Mikrometer zum Hauptemissionsbereich 5 in vertikaler Richtung, also in einer Richtung entlang der Aufwachsrichtung des aktiven Bereichs 3, auf. Die vom Nebenemissionsbereich 6 abgestrahlte kohärente elektromagnetische Strahlung ergibt sich durch eine zusätzliche Mode in der Halbleiterschichtenfolge 1, die im Substrat 2 geführt wird. Die Halbleiterschichtenfolge 1 kann je nach Zusammensetzung der Materialien des aktiven Bereichs 3 beispielsweise als grüne, blaue oder ultraviolette Laserdiode ausgeführt sein.

In Figur 1B ist ein vertikales Fernfeldstrahlprofil 101 der von der Halbleiterschichtenfolge in Figur 1A abgestrahlten kohärenten elektromagnetischen Strahlung gezeigt. Auf der horizontalen X-Achse ist dabei der Abstrahlwinkel $\Phi$ in Grad relativ zur Abstrahlrichtung gezeigt. Auf der vertikalen Y-Achse ist die relative Intensität der abgestrahlten kohärenten elektromagnetischen Strahlung in beliebigen Einheiten aufgebracht. Erkennbar ist bei 0°, also entlang der Abstrahlrichtung, ein Maximum, das der maximal abgestrahlten Intensität von kohärenter elektromagnetischer Strahlung vom Hauptemissionsbereich 5 entspricht. Daneben ist unter einer Richtung, die etwa 20° gegen die Abstrahlrichtung der Hauptemission geneigt ist, ein Seitenpeak 102 erkennbar, der durch kohärente elektromagnetische Strahlung hervorgerufen wird, die vom Nebenemissionsbereich 6 abgestrahlt wird. Die Nebenemission weist dabei eine geringere Intensität als die Hauptemission entlang der Abstrahlrichtung auf.

In den folgenden Figuren ist die Halbleiterschichtenfolge 1 jeweils in einer schematischen Darstellung gezeigt, die einem vertikalen Schnitt durch die Halbleiterschichtenfolge 1 in Figur 1A durch den Hauptemissionsbereich 5 und den Nebenemissionsbereich 6 entspricht. Der Übersichtlichkeit halber sind in den folgenden Figuren von der Halbleiterschichtenfolge 1 lediglich das Substrat 2 und der aktive Bereich 3 gezeigt, wohingegen der Hauptemissionsbereich 5, der Nebenemissionsbereich 6, die elektrischen Kontaktschichtenfolgen 8, 9 sowie elektrische Anschlussmöglichkeiten wie etwa Bonddrähte und/oder Lötmittel nicht gezeigt sind.

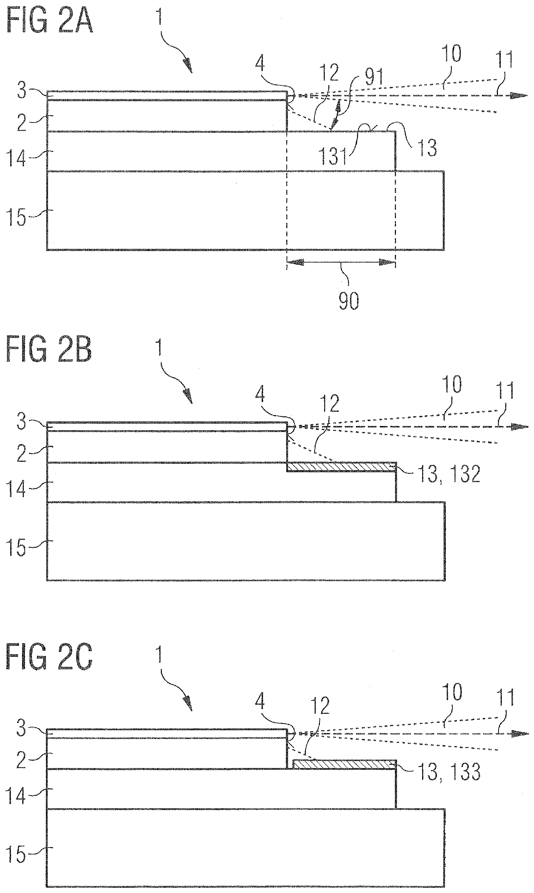

Die Laserlichtquelle gemäß dem Ausführungsbeispiel in Figur 2A weist zusätzlich zur Halbleiterschichtenfolge 1 eine Wärmesenke 14 auf, auf der die Halbleiterschichtenfolge 1 mit der dem aktiven Bereich 3 gegenüberliegenden Substratunterseite aufgelötet ist. Die Wärmesenke 14 weist ein Material mit hoher Wärmeleitfähigkeit auf, so dass die im Betrieb in der Halbleiterschichtenfolge 1 entstehende Wärme effizient abgeleitet werden kann. Zusammen mit der Wärmesenke 14 ist die Halbleiterschichtenfolge 1 auf einem Träger 15 aufgebracht, der beispielsweise ein Teil eines Gehäuses sein kann, insbesondere beispielsweise eines üblichen Laserdioden-Packages wie etwa eines TO38-Packages.

Weiterhin sind die Strahlungsauskoppelfläche 4 sowie die vom Hauptemissionsbereich 5 abgestrahlte kohärente elektromagnetische Strahlung 10 gezeigt, die entlang der Abstrahlrichtung 11 in einem Abstrahlkegel emittiert wird, durch den sich das in Figur 1B gezeigte vertikale Fernfeldstrahlprofil ohne den Seitenpeak 102 ergibt. Weiterhin ist auch die vom Nebenemissionsbereich 6 der Strahlungsauskoppelfläche 4 emittierte kohärente Strahlung gezeigt, die hinsichtlich ihrer Abstrahlrichtung einen Winkel 91 mit der Abstrahlrichtung 11 der Hauptemission 10 einschließt, wobei der Winkel 91 dem in Figur 1B gezeigten Winkel Φ entspricht. Wie in Figur 1B gezeigt ist, wird die Nebenemission 12 unter einem Winkel von etwa 20 Grad zur Abstrahlrichtung 11 der Hauptemission 10 abgestrahlt. Der Winkel 91 ist dabei rein beispielhaft zu verstehen und nicht beschränkend für das hier gezeigte sowie die folgenden Ausführungsbeispiele zu sehen. Vielmehr können die Halbleiterschichtenfolgen 1 der hier gezeigten Laserlichtquellen vom Nebenemissionsbereich 6 kohärente elektromagnetische Strahlung 12 auch unter anderen Winkeln relativ zur Abstrahlrichtung 11 emittieren.

Die Laserlichtquelle gemäß dem Ausführungsbeispiel in Figur 2A weist weiterhin ein Filterelement 13 auf, das als Teil der der Halbleiterschichtenfolge 1 zugewandten Oberfläche der Wärmesenke 14 ausgeführt ist. Der als Filterelement 13 ausgeführte Oberflächenbereich 131 der Wärmesenke 14 weist dabei eine Länge 90 auf, die derart gewählt ist, dass die vom Nebenemissionsbereich 6 abgestrahlte kohärente elektromagnetische Strahlung 12 auf das Filterelement 13 trifft. Dadurch kann die Nebenemission 12 effektiv abgeschattet werden. Der erforderliche Mindestabstand der der Strahlungsauskoppelfläche 4 in Abstrahlrichtung 11 nachgeordneten Kante der Wärmesenke 14, also das erforderliche Mindestmaß der Länge 90, ist abhängig vom Abstand des Nebenemissionsbereichs 6 zur dem aktiven Bereich 3 gegenüber liegenden Unterseite der Halbleiterschichtenfolge 1 und dem Winkel 91 zwischen der Abstrahlrichtung der Nebenemission 12 und der Abstrahlrichtung 11 der Hauptemission 10. Bezeichnet man die Höhe des Nebenemissionsbereichs 6 über der Halbleiterschichtenfolgenunterseite mit h, den Winkel 91 mit Φ und die Länge 90 mit a, so ergibt sich als Mindestmaß für die Länge 90 beziehungsweise a:

$$a > h/\tan \Phi$$

Für typische Winkel 91 beziehungsweise Φ und typische Halbleiterschichtenfolgen 1 ergeben sich für die Länge 90 beziehungsweise a Werte zwischen etwa 27 Mikrometer und etwa 165 Mikrometer. Als besonders geeignet hat sich eine Länge 90 beziehungsweise a von etwa 150 Mikrometer erwiesen. Die Länge 90 beziehungsweise a ist dabei noch klein genug, um den Emissionskegel der Hauptemission 10 nicht oder nur unwesentlich einzuschränken.

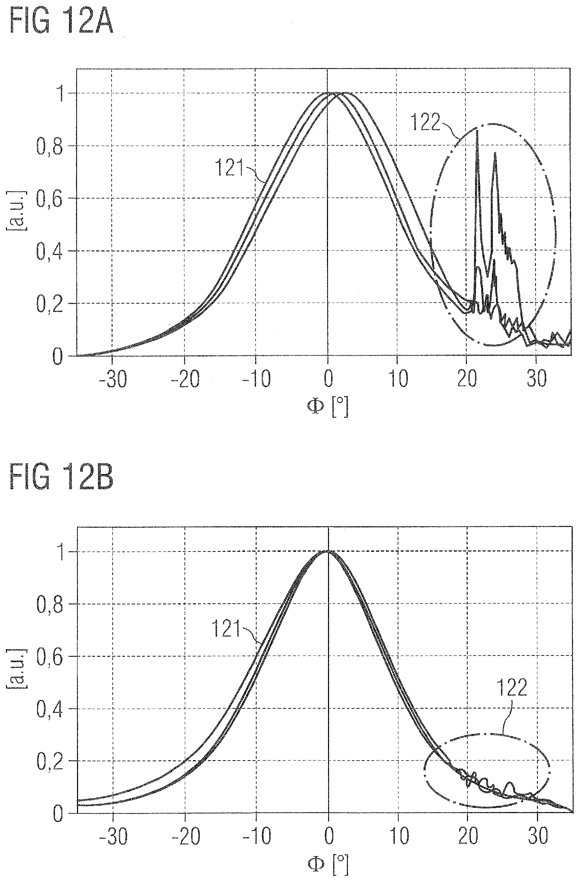

In den Figuren 12A und 12B sind jeweils eine Mehrzahl von vertikalen Fernfeldstrahlprofilen 121 der von

Laserlichtquellen abgestrahlten kohärenten elektromagnetischen Strahlung gezeigt, wobei in Figur 12A Laserlichtquellen mit üblichen Wärmesenken verwendet wurden, die nur etwa 20 μm über die Strahlungsauskoppelfläche 4 in Abstrahlrichtung hinausragt, während für die Messungen in Figur 12B Wärmesenken gemäß dem Ausführungsbeispiel in Figur 2A mit einer Länge 90 von etwa 150 μm verwendet wurde. Gut zu erkennen ist im Vergleich der Figuren 12A und 12B, dass im Winkelbereich 122 zwischen etwa 20° und etwa 30° durch das durch den Oberflächenbereich 131 der Wärmesenke 14 gebildete Filterelement 13 die Nebenemission 12 sehr effektiv abgeschattet wird und auch keine Reflexionen dieser erkennbar sind. Vertikale Fernfeldstrahlprofile, wie sie in Figur 12B gezeigt sind, eignen sich im Vergleich zu den Fernfeldstrahlprofilen 121 gemäß Figur 12A beispielsweise für Projektionsanwendungen, da die von den Laserlichtquellen abgestrahlte kohärente elektromagnetische Strahlung jeweils ein gaußförmiges Strahlprofil ohne Nebenpeaks zeigt.

Wie in Figur 2A gezeigt ist, weist das Filterelement 13 eine Haupterstreckungsebene auf, die parallel zur Abstrahlrichtung 11 der Hauptemission 10 ist.

Zur Unterdrückung möglicher Reflexionen an dem als Filterelement 13 ausgeführten Oberflächenbereich 131 der Wärmesenke 14 kann gemäß dem Ausführungsbeispiel in Figur 2B zusätzlich auf der Wärmesenke 14 ein Absorber 132 aufgebracht sein, der sich flächig und parallel zur Abstrahlrichtung 11 von der Strahlungsauskoppelfläche 4 weg erstreckt. Der Absorber 132 kann dabei eines der oben im allgemeinen Teil genannten Materialien aufweisen, die geeignet sind, die von der Halbleiterschichtenfolge 1 erzeugte kohärente elektromagnetische Strahlung 12 zu absorbieren.

Gemäß dem Ausführungsbeispiel in Figur 2C kann als Filterelement auf der Wärmesenke auch eine Diode oder, wie gezeigt, eine Fotodiode 133 als Filterelement aufgebracht sein. Dadurch kann die vom Nebenemissionsbereich 6 emittierte kohärente elektromagnetische Strahlung 12 genutzt werden, um die Ausgangsleistung der Halbleiterschichtenfolge 1 und damit der Laserlichtquelle zu messen. Die Fotodiode 133 kann weiterhin auch als ESD-Diode mit der Halbleiterschichtenfolge 1 verschaltet sein. Alternativ dazu kann anstelle der Fotodiode 133 auch eine ESD-Schutzdiode ohne Monitoringfunktion als Filterelement 13 genutzt werden. Die Anpassung der korrekten Höhe der Fotodiode 133 kann über eine Stufe in der Wärmesenke 114 erfolgen (nicht gezeigt), so dass keine Abschattung der vom Hauptemissionsbereich 5 abgestrahlten kohärenten elektromagnetischen Strahlung 10 erfolgt.

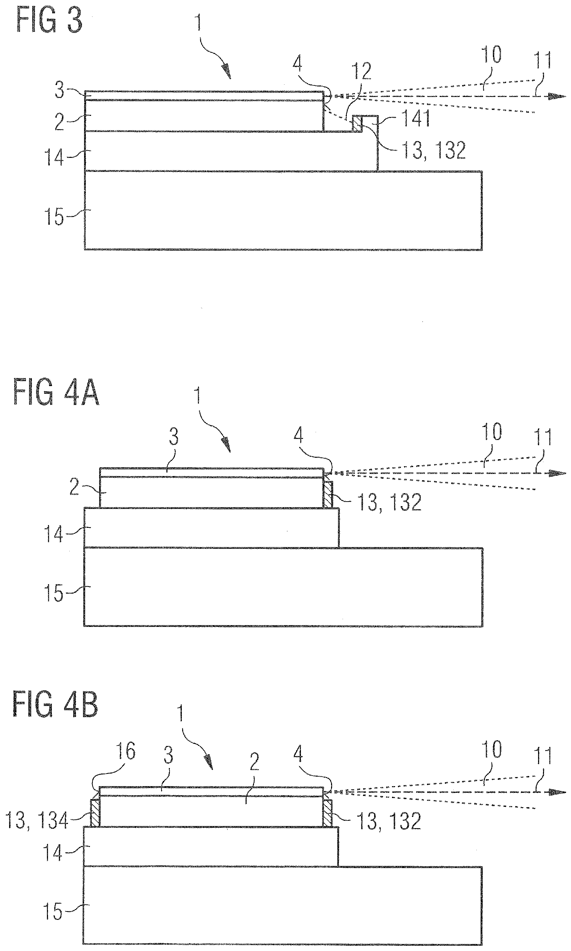

Gemäß der Laserlichtquelle in Figur 3, die in Verbindung mit dem Filterelement in Figur 2A ein Ausführungsbeispiel darstellt, weist die Wärmesenke 14 eine Stufe 141 auf, die eine der Halbleiterschichtenfolge 1 zugewandte Seitenfläche aufweist, auf der ein als Filterelement 13 ausgeführter Absorber 132 aufgebracht ist. Die Höhe der Stufe ist dabei derart angepasst, dass die vom Hauptemissionsbereich 5 emittierte kohärente elektromagnetische Strahlung 10 nicht oder nur unwesentlich abgeschattet wird. Alternativ zum gezeigten Ausführungsbeispiel kann auch die der Halbleiterschichtenfolge 1 zugewandte Seitenfläche der Stufe 141 das Filterelement bilden, ohne dass ein Absorber 132 darauf angeordnet ist.

In Figur 4A ist eine weitere Laserlichtquelle gezeigt, die in Verbindung mit dem Filterelement in Figur 2A ein Ausführungsbeispiel für eine Laserlichtquelle darstellt. Dabei ist das Filterelement 13 als Absorber 132 ausgeführt, der unmittelbar auf der Strahlungsauskoppelfläche 4 angeordnet ist. Der Absorber 132 kann dabei eines der oben im allgemeinen Teil genannten Materialien aufweisen. Wird als Absorbermaterial ein elektrisch leitendes Material wie etwa ein Metall verwendet, so kann eine Kurzschlussgefahr der Halbleiterschichtenfolge 1 dadurch ausgeschlossen werden, dass die Strahlungsauskoppelfläche 4 mittels einer oder mehrerer Passivierungsschichten passiviert und damit elektrisch isoliert ist. Wird als Absorbermaterial ein Dielektrikum wie etwa eines der im allgemeinen Teil genannten Oxide oder Oxinitride aufgebracht, so kann zur Steigerung beziehungsweise zur Steuerung der absorbierenden Wirkung des Filterelements 13 der Absorber 132 partiell unter Sauerstoffmangel abgeschieden werden. Mittels anschließendem Tempern in einer O2-Atmosphäre kann die Absorption wieder verringert werden, so dass über den Sauerstoffgehalt und die Temperbedingungen der Absorptionsgrad des Absorbers 132 einstellbar ist. Der Absorber 132 ist im gezeigten Ausführungsbeispiel derart auf der Strahlungsauskoppelfläche 4 der Halbleiterschichtenfolge 1 aufgebracht, dass lediglich der Nebenemissionsbereich 6 bedeckt ist, der Hauptemissionsbereich 5 hingegen frei bleibt.

Wie in der Figur 4B gezeigt ist, kann zusätzlich zu einem ersten Absorber 132 auf der Strahlungsauskoppelfläche 4 ein zweiter Absorber 134 auf der der Strahlungsauskoppelfläche 4 gegenüberliegenden Rückseitenfläche 16 aufgebracht werden. Alternativ dazu ist es auch möglich, dass nur auf der Rückseitenfläche 16 ein Absorber 134 als Filterelement 13 aufgebracht ist. Für den zweiten Absorber 134 gilt das vorab für den ersten Absorber 132 gesagte ebenso.

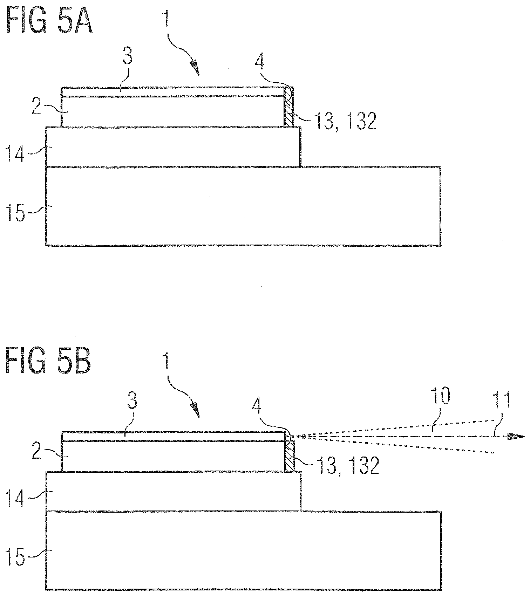

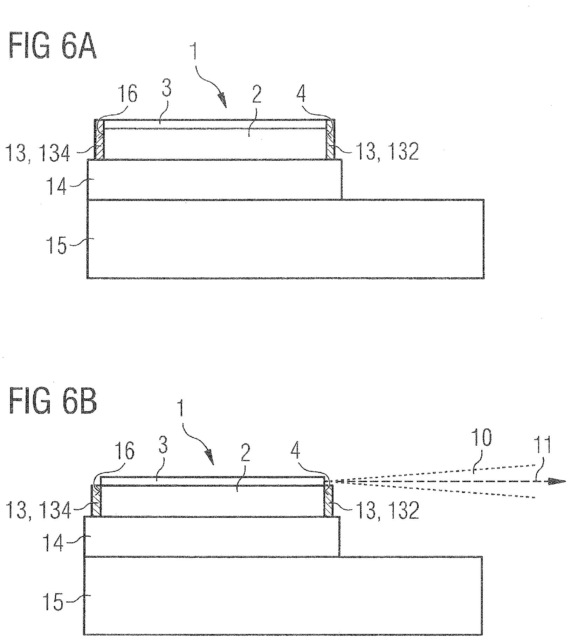

In den Figuren 5A und 5B ist ein Verfahren gezeigt, bei dem eine Absorberschicht 132 derart auf der Strahlungsauskoppelfläche 4 aufgebracht wird, dass der Absorber 132 die Strahlungsauskoppelfläche 4 gänzlich bedeckt. Der Absorber 132 kann dabei eine Polymerschicht, eine kohlenstoffhaltige Schicht, eine absorbierende Oxidschicht und/oder eine dünne Metallschicht aufweisen, deren Dicke derart gering ist, dass der Absorber 132 bei Inbetriebnahme der Halbleiterschichtenfolge 1 durch die vom Hauptemissionsbereich 5 emittierte kohärente elektromagnetische Strahlung 10 zumindest teilweise oder auch gänzlich weggebrannt oder in der Absorptivität derart verändert wird, dass die Hauptemission 12 von der Laserlichtquelle abgestrahlt werden kann. Die Dicke des Absorbers 132 ist weiterhin derart angepasst, dass die Intensität der vom Nebenemissionsbereich 6 abgestrahlten kohärenten elektromagnetischen Strahlung 10 nicht ausreicht, um den Absorber 132 wegzubrennen. Dadurch kann ein Filterelement 13 in Form einer selbstjustierenden Blende auf der Strahlungsauskoppelfläche 4 hergestellt werden. Das Wegbrennen beziehungsweise Ausbleichen des Absorbers 132 kann in einer kontrollierten Atmosphäre, beispielsweise einer O2- oder einer O3-Atmosphäre, stattfinden. In den Figuren 6A und 6B ist ein ähnliches Verfahren gezeigt, wobei im Vergleich zu den Figuren 5A und 5B zusätzlich zum ersten Absorber 132 auf der Strahlungsauskoppelfläche 4 ein zweiter Absorber 134 auf der der Strahlungsauskoppelfläche 4 gegenüber liegenden Rückseitenfläche 16 der Halbleiterschichtenfolge 1 aufgebracht wird. Je nach Ausgestaltung der Rückseitenfläche 16 der Halbleiterschichtenfolge 1 kann bei Inbetriebnahme der Halbleiterschichtenfolge 1 auch der zweite Absorber 134 in einem Bereich, der dem Hauptemissionsbereich 5 der Strahlungsauskoppelfläche 4 auf der Rückseitenfläche 16 gegenüberliegt, weggebrannt werden.

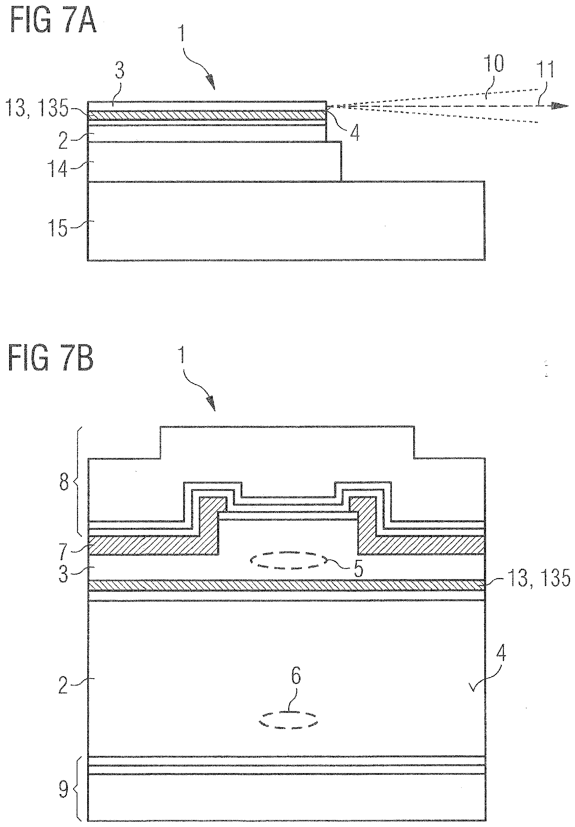

In der Laserlichtquelle der Figuren 7A und 7B, die in Verbindung mit dem Filterelement der Figur 2A ein Ausführungsbeispiel darstellt, sind eine Schnittdarstellung einer Laserlichtquelle beziehungsweise eine Frontansicht auf die Strahlungsauskoppelfläche 4 einer zugehörigen Halbleiterschichtenfolge 1 gezeigt, wobei das Filterelement 13 in diesem Ausführungsbeispiel als absorbierendes halbleitendes Material 135 ausgebildet ist, das zwischen dem Hauptemissionsbereich 5 und dem Substrat 2 angeordnet ist. Dazu kann während des epitaktischen Wachstums des aktiven Bereichs 3 eine dünne Schicht aus dem absorbierenden, halbleitenden Material 135 auf dem Substrat 2 aufgebracht werden. Weist die Halbleiterschichtenfolge 1 beispielsweise wie in Figur 1A gezeigt eine Nitrid-basiertes Verbindungshalbleitermaterialsystem auf, kann die Absorberschicht mit dem absorbierenden, halbleitenden Material 135 beispielsweise als InGaN-Schicht mit defektreichen Gebieten ausgebildet werden, die beispielsweise durch Tempern herstellbar sind, oder als InGaN-Schicht mit InGaN-Inhomogenitäten, die durch entsprechende Aufwachsbedingungen herstellbar sind. Alternativ dazu kann die Absorberschicht mit dem absorbierenden, halbleitenden Material 135 auch eine Mehrzahl von Schichten aus absorbierenden, halbleitenden Materialien aufweisen.

Durch das absorbierende, halbleitende Material 135 kann eine Ausbreitung von kohärenter elektromagnetischer Strahlung in das Substrat 2 verhindert oder zumindest vermindert werden, so dass im Nebenemissionsbereich 6 keine oder eine intensitätsschwächere kohärente elektromagnetische Strahlung 12 abgestrahlt werden kann.

Zusätzlich kann auf der dem aktiven Bereich 3 abgewandten Seite der Absorberschicht 135 eine oder mehrere reflektierende Schichten oder eine reflektierende Schichtenfolge angeordnet sein, durch die kohärente elektromagnetische Strahlung, die die Absorberschicht 135 in einem ersten Durchgang durchdringen kann, wieder zurück zur Absorberschicht 135 reflektiert wird und dort in einem zweiten Durchgang absorbiert werden kann.

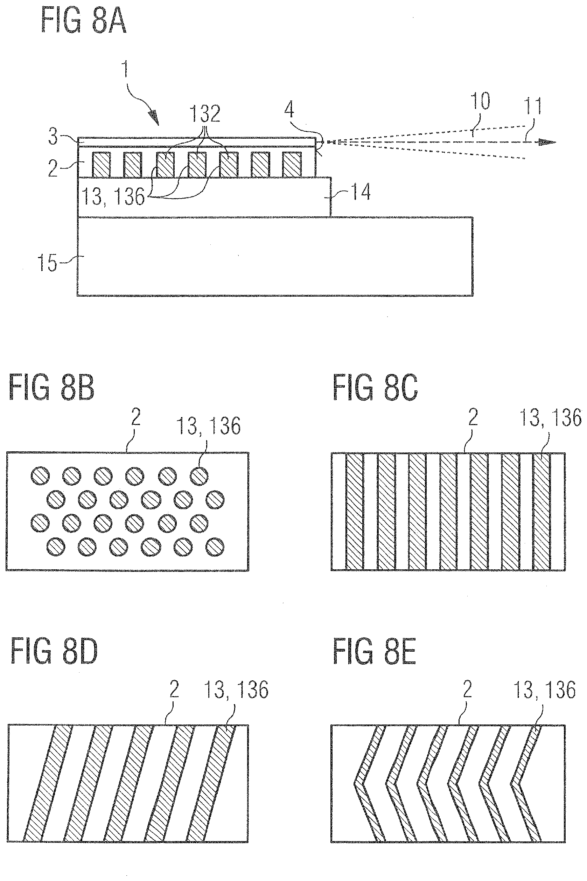

In Figur 8A ist eine weitere Laserlichtquelle gezeigt, die in Verbindung mit dem Fiel der Figur 2A ein Ausführungsbeispiel für eine Laserlichtquelle darstellt, bei der das Filterelement 13 zumindest eine Ausnehmung 136 im Substrat 2 umfasst, die in der dem aktiven Bereich 3 gegenüberliegenden Unterseite des Substrats 2 angeordnet ist. Wie im Ausführungsbeispiel in Figur 8A gezeigt ist, kann das Filterelement 13 auch eine Mehrzahl solcher Ausnehmungen 136 im Substrat 2 aufweisen. Die eine oder die Mehrzahl von Ausnehmungen 136 können dabei, wie in den Figuren 8B bis 8E gezeigt ist, als Bohrungen in Form von Kanälen senkrecht zur Hauptstreckungsrichtung der Halbleiterschichtenfolge, also in vertikaler Richtung, ausgebildet sein (Figur 8B) oder können als Kanäle in der Haupterstreckungsebene der Halbleiterschichtenfolge 1 und damit senkrecht zur vertikalen Richtung gerade, schräg oder auch geknickt angeordnet sein (Figuren 8C, 8D und 8E). Die eine oder die Mehrzahl von Ausnehmungen 136 können dabei frei von Material sein (nicht gezeigt) oder, wie vorliegend gezeigt, mit einem Absorbermaterial 132 zumindest teilweise oder gänzlich gefüllt sein. Als Absorbermaterial eignet sich eines der oben genannten Materialien. Alternativ oder zusätzlich können die Ausnehmungen 136 auch mit einem gut wärmeleitenden Material zumindest teilweise oder gänzlich gefüllt sein. Besonders vorteilhaft ist hier galvanisch abgeschiedenes Gold, das sowohl eine gute Wärmeleitung als auch eine hohe Absorption aufweist.

Die eine Ausnehmung 136 oder die Mehrzahl von Ausnehmungen 136 ragen dabei derart weit in das Substrat 2 von der Unterseite her hinein, dass sie in vertikaler Richtung mit dem Nebenemissionsbereich 6 überlappen, so dass eine Ausbreitung von kohärenter elektromagnetischer Strahlung im Substrat 2 in diesem Bereich unterdrückt oder sogar verhindert werden kann.

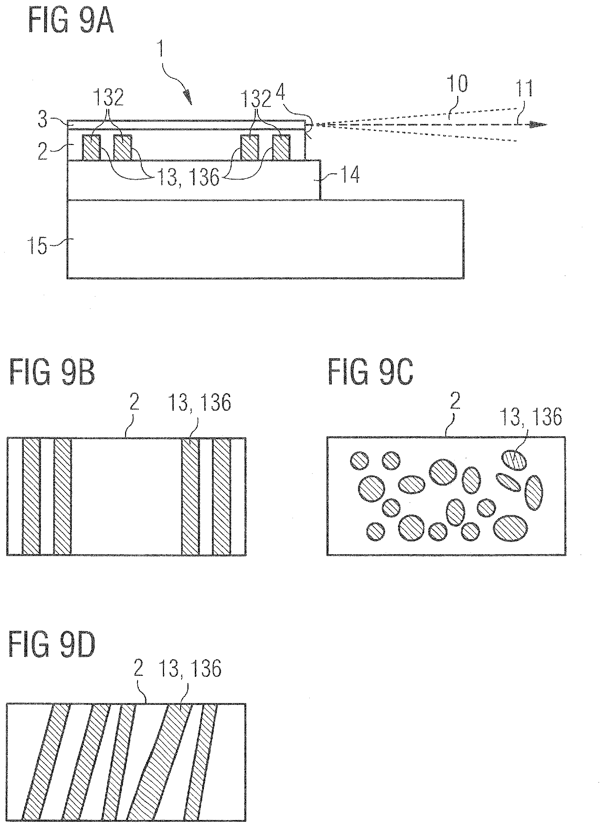

Die Ausnehmungen 136 sind beispielsweise durch Ansägen, durch eine Fototechnik und Trockenätzen oder Nassätzen oder andere bekannte Strukturierungsmethoden herstellbar. Wie in den Figuren 8A bis 8E gezeigt ist, können die Ausnehmungen 136 dabei periodisch und regelmäßig im Substrat verteilt sein. Alternativ dazu kann, wie in den Figuren 9A bis 9D gezeigt ist, die Mehrzahl von Ausnehmungen 136, die das Filterelement 13 bilden, derart im Substrat verteilt sein, dass keine periodische Struktur gebildet wird. Ansonsten gilt für die in den Figuren 9A bis 9D gezeigten Ausführungsbeispiele das zu den Figuren 8A bis 8E Gesagte.

Alternativ oder zusätzlich zu den Ausnehmungen 136, die in Figuren 8A bis 9D gezeigt sind, kann das Filterelement 13 auch zumindest eine Ausnehmung aufweisen, die sich von der Strahlungsauskoppelfläche entlang der Abstrahlrichtung 11 bis zu der Strahlungsauskoppelfläche 4 gegenüberliegenden Rückseitenfläche erstreckt.

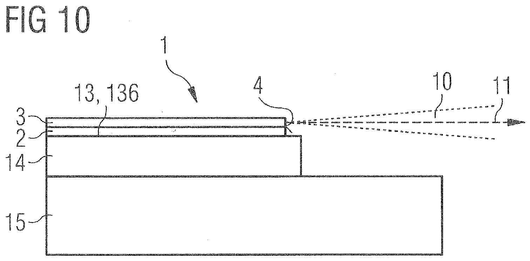

Im Ausführungsbeispiel in Figur 10 ist eine Laserlichtquelle mit einer Halbleiterschichtenfolge 1 gezeigt, bei der sich die Ausnehmung 136 über die ganze Haupterstreckungsebene des Substrats 2 erstreckt, so dass das Substrat 2 in seiner Dicke derart reduziert ist, dass der Nebenemissionsbereich 6 entfernt ist. Neben einem solchen partiellen Entfernen des Substrats 2 kann das Substrat 2 auch komplett beziehungsweise bis auf eine Mindestrestdicke von wenigen Mikrometern entfernt werden.

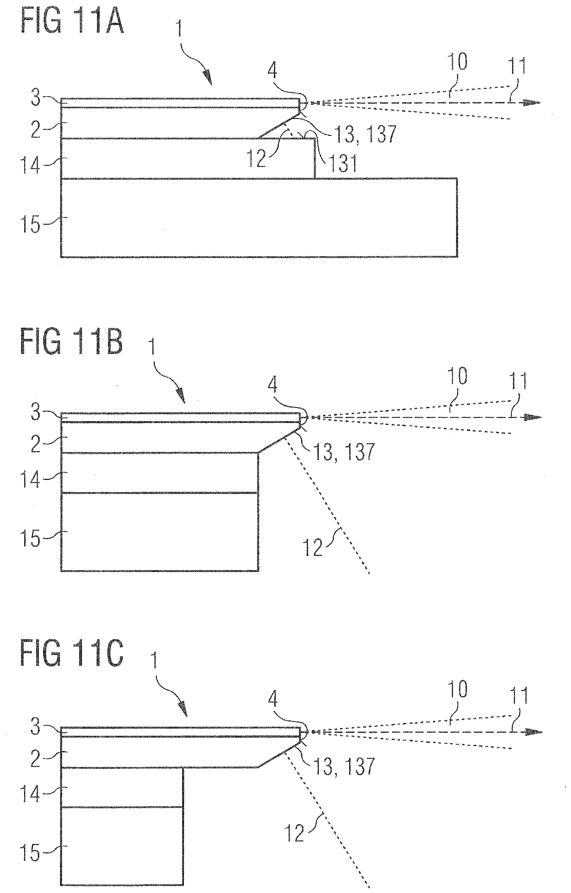

In den Figuren 11A bis 11C sind Laserlichtquellen gezeigt, die in Verbindung mit dem Filterelement der Figur 2A weitere Ausführungsbeispiele für Laserlichtquellen darstellen, bei denen das Filterelement 13 als Ausnehmung im Substrat 2 ausgeführt ist, wobei die Ausnehmung jeweils als Anschrägung 137 in der Strahlungsauskoppelfläche 4 ausgebildet ist. Dabei ist der Nebenemissionsbereich 6 durch zumindest einen Teil der Anschrägung 137 gebildet, wodurch erreicht wird, dass die vom Nebenemissionsbereich 6 emittierte kohärente elektromagnetische Strahlung 12 weiter aus der Emissionsrichtung der Hauptemission 10 entlang der Abstrahlrichtung 11 heraus gelenkt wird und so im Fernfeld nicht mehr vorhanden ist. Dabei kann wie in Figur 11A gezeigt ein Oberflächenbereich 131 der Wärmesenke 14 oder auch ein zusätzlicher Absorber oder eine Diode oder Fotodiode wie in den Ausführungsbeispielen gemäß der Figuren 2A bis 2C einen zusätzlichen Teil des Filterelements 13 ausbilden.

Wie in den Figuren 11B und 11C gezeigt ist, kann sich die Halbleiterschichtenfolge 1 auch über die Wärmesenke 14 und den Träger 15 hinweg strecken.

Alternativ zu der in den Ausführungsbeispielen gezeigten Montage der Halbleiterschichtenfolge 1 mit dem Substrat 2 auf der Wärmesenke 14 kann die Halbleiterschichtenfolge 1 auch mit dem Substrat 2 von der Wärmesenke 14 weggewandt auf der Wärmesenke 14 aufgebracht werden. Weist die Halbleiterschichtenfolge eine typische Aufwachsreihenfolge auf, bei der auf dem Substrat 2 zuerst die n-leitenden Schichten und dann die p-leitenden Schichten des aktiven Bereichs 3 aufgewachsen sind, so spricht man in diesem Fall auch von einer so genannten p-side-down-Montage, während in den Figuren rein beispielhaft eine p-side-up-Montage gezeigt ist.

Die in den gezeigten Ausführungsbeispielen und im allgemeinen Teil beschriebenen Filterelemente können auch miteinander kombiniert werden, so dass eine Laserlichtquelle gemäß der vorliegenden Anmeldung auch eine Kombination der beschriebenen und gezeigten Filterelemente aufweisen kann.

Die Erfindung ist nicht durch die Beschreibung anhand der Ausführungsbeispiele auf diese beschränkt. Vielmehr umfasst die Erfindung die Kombination von Merkmalen in den Patentansprüchen.

**Patentansprüche**

1. Laserlichtquelle zur Abstrahlung von kohärenter elektromagnetischer Strahlung (10) mit einem vertikalen Fernfeldstrahlprofil (121), umfassend

    - eine Halbleiterschichtenfolge (1) zur Erzeugung der kohärenten elektromagnetischen Strahlung mit einem Substrat (2) und einem aktiven Bereich (3) auf dem Substrat (2), wobei die kohärente elektromagnetische Strahlung im Betrieb mindestens von einem Hauptemissionsbereich (5) einer Strahlungsauskoppelfläche (4) mit einer Abstrahlrichtung (11) abgestrahlt wird und die Strahlungsauskoppelfläche (4) durch eine Seitenfläche der Halbleiterschichtenfolge (1) gebildet ist,

    - mindestens ein Filterelement (13), das im Betrieb erzeugte kohärente elektromagnetische Strahlung (12), die von einem zum Hauptemissionsbereich (5) vertikal versetzten und räumlich getrennten Nebenemissionsbereich (6) der Strahlungsauskoppelfläche (4) abgestrahlt wird, im vertikalen Fernfeldstrahlprofil (121) unterdrückt, wobei die vertikale Richtung durch eine Aufwachsrichtung von Schichten der Halbleiterschichtenfolge bestimmt wird, und

    - eine Wärmesenke (14), wobei die Halbleiterschichtenfolge (1) sowie das mindestens eine Filterelement (13) jeweils auf der Wärmesenke (14) angeordnet sind, **dadurch gekennzeichnet, dass** sich ein Filterelement (13) vertikal versetzt zum Hauptemissionsbereich (5) und zum Nebenemissionsbereich (6) von der Strahlungsauskoppelfläche (4) weg erstreckt, wobei das Filterelement (13) eine Hauptersteckungsebene aufweist, die parallel zur Abstrahlrichtung (11) ist, und wobei das Filterelement (13) als Teil der der Halbleiterschichtenfolge (1) zugewandten Oberfläche der vor der Strahlungsauskoppelfläche (4) angeordneten, sich von der Strahlungsauskoppelfläche (4) wegerstreckenden Wärmesenke (14) ausgeführt ist.

2. Laserlichtquelle nach Anspruch 1, wobei das mindestens eine Filterelement eine Kombination von Filterelementen aufweist, wobei die Wärmesenke (14) eine Stufe (141) aufweist und ein Filterelement (13) auf einer der Halbleiterschichtenfolge (1) zugewandten Seitenfläche der Stufe (141) angeordnet ist.

3. Laserlichtquelle nach einem der beiden vorherigen Ansprüche, wobei ein Filterelement (13) einen Absorber (132), eine Diode und/oder eine Fotodiode (133) umfasst.

4. Laserlichtquelle nach Anspruch 1, wobei das mindestens eine Filterelement eine Kombination von Filterelementen aufweist, wobei ein Filterelement (13) zumindest eine Ausnehmung (136, 137) in einer dem aktiven Bereich (3) gegenüberliegenden Unterseite des Substrats (2) umfasst.

5. Laserlichtquelle nach dem vorherigen Anspruch, wobei die zumindest eine Ausnehmung (136) von der Strahlungsauskoppelfläche (4) und/oder einer der Strahlungsauskoppelfläche (4) gegenüberliegenden Rückseitenfläche (16) des Substrats (2) jeweils beabstandet ist.

6. Laserlichtquelle nach einem der beiden vorherigen Ansprüche, wobei die zumindest eine Ausnehmung (136) eine Mehrzahl von Ausnehmungen (136) umfasst, die in Abstrahlrichtung (11) nacheinander angeordnet sind.

**7.** Laserlichtquelle nach einem der Ansprüche 4 bis 6, wobei die zumindest eine Ausnehmung ein Sackloch oder ein gerader oder geknickter Kanal entlang und/oder quer zur Abstrahlrichtung ist.

**8.** Laserlichtquelle nach Anspruch 4, wobei sich die Ausnehmung (136) von der Strahlungsauskoppelfläche (4) zu einer der Strahlungsauskoppelfläche (4) gegenüberliegenden Rückseitenfläche (16) des Substrats (2) erstreckt.

**9.** Laserlichtquelle nach einem der Ansprüche 4 bis 8, wobei die zumindest eine Ausnehmung (136) zumindest teilweise mit einem die kohärente elektromagnetische Strahlung absorbierenden Material (132) und/oder einem wärmeleitenden Material gefüllt ist.

**10.** Laserlichtquelle nach Anspruch 4, wobei die Ausnehmung eine Anschrägung (137) des Substrats (2) an der Strahlungsauskoppelfläche (4) umfasst und der Nebenemissionsbereich (6) durch zumindest einen Teil der Anschrägung (137) gebildet ist.

**11.** Laserlichtquelle nach Anspruch 1, wobei das mindestens eine Filterelement eine Kombination von Filterelementen aufweist, wobei ein Filterelement (13) zumindest eine Absorberschicht zwischen dem Hauptemissionsbereich (5) und dem Substrat (2) umfasst, die ein die kohärente elektromagnetische Strahlung absorbierendes, halbleitendes Material (135) aufweist.

**12.** Laserlichtquelle nach Anspruch 11, wobei zwischen der zumindest einen Absorberschicht und dem Substrat (2) eine reflektierende Schicht angeordnet ist.

**13.** Laserlichtquelle nach Anspruch 1, wobei das mindestens eine Filterelement eine Kombination von Filterelementen aufweist, wobei ein Filterelement (13) einen ersten Absorber (132) für die von der Halbleiterschichtenfolge (1) erzeugte kohärente elektromagnetische Strahlung unmittelbar auf der Strahlungsauskoppelfläche (4) und/oder einen zweiten Absorber (134) unmittelbar auf einer der Strahlungsauskoppelfläche (4) gegenüberliegenden Rückseitenfläche (16) der Halbleiterschichtenfolge (1) aufweist.

**14.** Laserlichtquelle nach Anspruch 13, wobei die vom Hauptemissionsbereich (5) abgestrahlte elektromagnetische Strahlung zu einer selbstjustierenden Verringerung der Absorptionswirkung des ersten Absorbers (132) im Hauptemissionsbereich (5) und/oder des zweiten Absorbers (134) in einem dem Hauptemissionsbereich (5) gegenüberliegenden Bereich führt.

**Claims**

**1.** A laser light source for emitting coherent electromagnetic radiation (10) having a vertical far field beam profile (121), comprising

- a semiconductor layer sequence (1) for generating the coherent electromagnetic radiation, having a substrate (2) and an active region (3) on the substrate (2), the coherent electromagnetic radiation during operation being emitted at least from a main emission region (5) of a radiation-outcoupling surface (4) with an emission direction (11), and the radiation-outcoupling surface (4) being formed by a side surface of the semiconductor layer sequence (1),
- at least one filter element (13), which suppresses, in the vertical far-field beam profile (121), coherent electromagnetic radiation (12) generated during operation, which is emitted from a secondary emission region (6) of the radiation-outcoupling surface (4), which secondary emission region (6) is vertically offset and spatially separated from the main emission region (5), wherein the vertical direction is determined by a growth direction of layers of the semiconductor layer sequence, and
- a heat sink (14), the semiconductor layer sequence (1) and the at least one filter element (13) each being arranged on the heat sink (14),

**characterized in that**
a filter element (13) extends away from the radiation-outcoupling surface (4) in a vertically offset manner with respect to the main emission region (5) and the secondary emission region (6), wherein the filter element (13) has a main extension plane which is parallel to the emission direction (11), and wherein the filter element (13) is embodied as part of the surface, facing the semiconductor layer sequence (1), of the heat sink (14) arranged in front of the radiation-outcoupling surface (4) and extending away from the radiation-outcoupling surface (4).

**2.** The laser light source according to claim 1, wherein the at least one filter element comprises a combination of filter elements, wherein the heat sink (14) comprises a step (141) and a filter element (13) is arranged on a side surface of the step (141) facing the semiconductor layer sequence (1).

**3.** The laser light source according to one of the two previous claims, wherein a filter element (13) comprises an absorber (132), a diode and/or a photodiode (133).

**4.** The laser light source according to claim 1, wherein the at least one filter element comprises a combination of filter elements, wherein a filter element (13) comprises at least one recess (136, 137) in an underside of the substrate (2) opposite the active region (3).

5. The laser light source according to the previous claim, wherein the at least one recess (136) is spaced apart from the radiation-outcoupling surface (4) and/or a rear surface (16) of the substrate (2) opposite the radiation-outcoupling surface (4).

6. The laser light source according to one of the two previous claims, wherein the at least one recess (136) comprises a plurality of recesses (136) which are arranged one after the other in the emission direction (11) .

7. The laser light source according to one of the claims 4 to 6, wherein the at least one recess is a blind hole or is a straight or bent channel along and/or transverse to the emission direction.

8. The laser light source according to claim 4, wherein the recess (136) extends from the radiation-outcoupling surface (4) to a rear surface (16) of the substrate (2) opposite the radiation-outcoupling surface (4).

9. The laser light source according to one of the claims 4 to 8, wherein the at least one recess (136) is at least partially filled with a material (132) absorbing the coherent electromagnetic radiation and/or a heat-conducting material.

10. The laser light source according to claim 4, wherein the recess comprises a bevel (137) of the substrate (2) at the radiation-outcoupling surface (4) and the secondary emission region (6) is formed by at least part of the bevel (137).

11. The laser light source according to claim 1, wherein the at least one filter element comprises a combination of filter elements, wherein a filter element (13) comprises at least one absorber layer between the main emission region (5) and the substrate (2), which comprises a semiconducting material (135) absorbing the coherent electromagnetic radiation.

12. The laser light source according to claim 11, wherein a reflective layer is disposed between the at least one absorber layer and the substrate (2).

13. The laser light source according to claim 1, wherein the at least one filter element comprises a combination of filter elements, wherein a filter element (13) comprises a first absorber (132) for the coherent electromagnetic radiation generated by the semiconductor layer sequence (1) directly on the radiation-outcoupling surface (4) and/or a second absorber (134) directly on a rear surface (16) of the semiconductor layer sequence (1) opposite the radiation-outcoupling surface (4).

14. The laser light source according to claim 13, wherein the electromagnetic radiation emitted from the main emission region (5) leads to a self-adjusting reduction of the absorption effect of the first absorber (132) in the main emission region (5) and/or of the second absorber (134) in a region opposite the main emission region (5).

## Revendications

1. Source de lumière laser en vue de l'émission de rayonnement électromagnétique cohérent (10) avec un profil de rayonnement à champ lointain (121) comportant

- une succession de couches à semiconducteurs (1) en vue de la production du rayonnement électromagnétique cohérent avec un substrat (2) et une zone active (3) sur le substrat (2), sachant que le rayonnement électromagnétique cohérent est émis en fonctionnement au moins par une zone d'émission principale (5) d'une surface de découplage du rayonnement (4) avec une direction de rayonnement (11) et que la surface de découplage du rayonnement (4) est constituée par une surface latérale de la succession de couches à semiconducteurs (1),
- au moins un élément filtrant (13), qui inhibe du rayonnement électromagnétique cohérent (12) généré en fonctionnement, qui est émis par une zone d'émissions secondaire (6) décalée verticalement par rapport à la zone d'émissions principale (5) et séparée spatialement de celle-ci, dans le profil vertical de rayonnement à champ lointain (121), sachant que la direction verticale est déterminée par une direction d'épitaxie des couches de la succession de couches à semiconducteurs, et
- un dissipateur thermique (14), sachant que la succession de couches à semiconducteurs (1) ainsi qu'au moins l'un des éléments filtrants (13) sont disposés respectivement sur le dissipateur thermique (14),

**caractérisée**
**en ce qu'**un élément filtrant (13) s'étend en décalage vertical par rapport à la zone d'émission principale (5) et par rapport à la zone d'émissions secondaires (6) en s'écartant de la surface de découplage du rayonnement (4), sachant que l'élément filtrant (13) présente un plan d'extension principal, qui est parallèle à la direction de rayonnement (11), et sachant que l'élément filtrant (13) est exécuté comme partie de la surface tournée vers la succession de couches à semiconducteurs (1) du dissipateur thermique (14) disposé en amont de la surface de découplage du rayonnement (4) et s'écartant de la surface de découplage du rayonnement (4).

2. Source de lumière laser selon la revendication 1, sachant qu'au moins l'un des éléments filtrants présente une combinaison d'éléments filtrants, sachant que le dissipateur thermique (14) présente un échelon (141) et qu'un élément filtrant (13) est disposé sur une des surfaces latérales de l'échelon (141) tournées vers la succession de couches à semiconducteurs (1).

3. Source de lumière laser selon une quelconque des deux revendications précédentes, sachant qu'un élément filtrant (13) comporte un absorbeur (132), une diode et/ou une photodiode (133).

4. Source de lumière laser selon la revendication 1, sachant qu'au moins l'un des éléments filtrants présente une combinaison d'éléments filtrants, sachant qu'un élément filtrant (13) comporte au moins un creux (136, 137) dans une face inférieure du substrat (2) située face à la zone active (2).

5. Source de lumière laser selon la revendication précédente, sachant qu'au moins l'un des creux (136) est écarté respectivement de la surface de découplage du rayonnement (4) et/ou d'une surface de partie arrière (16) située face à la surface de découplage du rayonnement (4) du substrat (2).

6. Source de lumière laser selon une quelconque des deux revendications précédentes, sachant qu'au moins l'un des creux (136) comporte une pluralité de creux (136), qui sont disposés l'un après l'autre dans la direction de rayonnement (11).

7. Source de lumière laser selon une quelconque des revendications 4 à 6, sachant qu'au moins l'un des creux est un trou borgne ou un canal droit ou infléchi le long de la direction de rayonnement et/ou transversalement à celle-ci.

8. Source de lumière laser selon la revendication 4, sachant que le creux (136) s'étend de la surface de découplage du rayonnement (4) vers une surface de partie arrière (16) située face à la surface de découplage du rayonnement (4) du substrat (2).

9. Source de lumière laser selon une quelconque des revendications 4 à 8, sachant qu'au moins l'un des creux (136) est chargé au moins partiellement d'un matériau (132) absorbant le rayonnement électromagnétique cohérent et/ou d'un matériau thermoconductible.

10. Source de lumière laser selon la revendication 4, sachant que le creux comporte une zone oblique (137) du substrat (2) sur la surface de découplage du rayonnement (4) et que la zone d'émission secondaire (6) est constituée par au moins une partie de la zone oblique (137).

11. Source de lumière laser selon la revendication 1, sachant qu'au moins l'un des éléments filtrants présente une combinaison d'éléments filtrants, sachant qu'un élément filtrant (13) comporte au moins une couche d'absorbant entre la zone d'émission principale (5) et le substrat, qui présente un matériau semiconducteur (135) absorbant le rayonnement électromagnétique cohérent.

12. Source de lumière laser selon la revendication 11, sachant qu'entre au moins l'une des couches d'absorbant et le substrat (2) est disposée une couche réfléchissante.

13. Source de lumière laser selon la revendication 1, sachant qu'au moins l'un des éléments filtrants présente une combinaison d'éléments filtrants, sachant qu'un élément filtrant (13) comporte un premier absorbant (132) pour le rayonnement électromagnétique cohérent généré par la succession de couches à semiconducteurs (1) directement sur la surface de découplage du rayonnement (4) et/ou un second absorbant (134) directement sur une surface de partie arrière (16) située face à la surface de découplage du rayonnement (4) de la succession de couches à semiconducteurs (1).

14. Source de lumière laser selon la revendication 13, sachant que le rayonnement électromagnétique émis par la zone d'émission principale (5) entraîne une réduction auto-ajustante de l'effet d'absorption du premier absorbant (132) dans la zone d'émissions principale (5) et/ou du second absorbant (134) dans une zone située face à la zone d'émission principale (5).

## FIG 1A

## FIG 1B

FIG 2A

FIG 2B

FIG 2C

**FIG 3**

**FIG 4A**

**FIG 4B**

FIG 5A

FIG 5B

FIG 6A

FIG 6B

FIG 7A

FIG 7B

FIG 8A

FIG 8B

FIG 8C

FIG 8D

FIG 8E

FIG 9A

FIG 9B

FIG 9C

FIG 9D

FIG 10

**FIG 11A**

**FIG 11B**

**FIG 11C**

FIG 12A

FIG 12B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010015197
- US 7103082 B2
- JP 2002280663 B
- US 20080102546 A
- DE 102008012859
- US 20080101422 A